# EUROPÄISCHE PATENTSCHRIFT

(11) **EP 1 543 562 B1**
(45) Veröffentlichungstag und Bekanntmachung des Hinweises auf die Patenterteilung: **26.12.2012**
(21) Anmeldenummer: 03747837.7
(22) Anmeldetag: 19.09.2003
(51) Int. Cl.: H01L 21/336, H01L 21/84, H01L 29/786, H01L 27/115, H01L 27/12

(54) **INTEGRIERTER FELDEFFEKTTRANSISTOR MIT ZWEI STEUERBEREICHEN, VERWENDUNG DIESES FELDEFFEKTTRANSISTORS UND HERSTELLUNGSVERFAHREN**
INTEGRATED FIELD-EFFECT TRANSISTOR COMPRISING TWO CONTROL REGIONS, USE OF SAID FIELD-EFFECT TRANSISTOR AND METHOD FOR PRODUCING THE SAME
TRANSISTOR A EFFET DE CHAMP INTEGRE A DEUX ZONES DE COMMANDE, UTILISATION ET PROCEDE DE FABRICATION DUDIT TRANSISTOR A EFFET DE CHAMP

(30) Priorität: 27.09.2002 DE 10245153
(43) Veröffentlichungstag der Anmeldung: 22.06.2005
(73) Patentinhaber: Infineon Technologies AG, 85579 Neubiberg (DE)
(72) Erfinder: KAKOSCHKE, Ronald, 81475 München (DE)
(74) Vertreter: Kindermann, Peter
(86) Internationale Anmeldenummer: PCT/DE2003/003131
(87) Internationale Veröffentlichungsnummer: WO 2004/032245

(56) Entgegenhaltungen:
- US-A- 4 996 574
- US-A- 5 683 918
- US-A- 5 930 605
- US-A1- 2002 130 354
- US-B1- 6 300 182
- US-B1- 6 396 108
- HWANG J M ET AL: "Premature breakdown in non-fully depleted SOI/MOSFETs with body-tied-to-source structure" SOI CONFERENCE, 1991. PROCEEDINGS, 1991., IEEE INTERNATIONAL VAIL VALLEY, CO, USA 1-3 OCT. 1991, NEW YORK, NY, USA,IEEE, US, 1. Oktober 1991 (1991-10-01), Seiten 34-35, XP010052868 ISBN: 0-7803-0184-6
- DAUN F L ET AL: "Design and analysis of a novel mixed accumulation/inversion mode FD SOI MOSFET" SOI CONFERENCE, 1997. PROCEEDINGS., 1997 IEEE INTERNATIONAL FISH CAMP, CA, USA 6-9 OCT. 1997, NEW YORK, NY, USA,IEEE, US, 6. Oktober 1997 (1997-10-06), Seiten 100-101, XP010256224 ISBN: 0-7803-3938-X
- MCDAID L J ET AL: "SUPPRESSION OF LATCH IN SOI MOSFETS BY SILICIDATION OF SOURCE" ELECTRONICS LETTERS, IEE STEVENAGE, GB, Bd. 27, Nr. 11, 23. Mai 1991 (1991-05-23), Seiten 1003-1005, XP000232464 ISSN: 0013-5194
- SLEIGHT J W ET AL: "DC AND TRANSIENT CHARACTERIZATION OF A COMPACT SCHOTTKY BODY CONTACT TECHNOLOGY FOR SOI TRANSISTORS" IEEE TRANSACTIONS ON ELECTRON DEVICES, IEEE INC. NEW YORK, US, Bd. 46, Nr. 7, Juli 1999 (1999-07), Seiten 1451-1456, XP000928441 ISSN: 0018-9383
- CRISTOLOVEANU S ET AL: "Recent advances in SOI materials and device technologies for high temperature" HIGH-TEMPERATURE ELECTRONIC MATERIALS, DEVICES AND SENSORS CONFERENCE, 1998 SAN DIEGO, CA, USA 22-27 FEB. 1998, NEW YORK, NY, USA,IEEE, US, 22. Februar 1998 (1998-02-22), Seiten 86-93, XP010313523 ISBN: 0-7803-4437-5
- KRISHNAN S: "Efficacy of body ties under dynamic switching conditions in partially depleted SOI CMOS technology" SOI CONFERENCE, 1997. PROCEEDINGS., 1997 IEEE INTERNATIONAL FISH CAMP, CA, USA 6-9 OCT. 1997, NEW YORK, NY, USA,IEEE, US, 6. Oktober 1997 (1997-10-06), Seiten 140-141, XP010256244 ISBN: 0-7803-3938-X

## Beschreibung

Die Erfindung betrifft einen integrierten Feldeffekttransistor mit einem Substratbereich, mindestens zwei dotierten Anschlussbereichen und einem Steuerbereich. Die Anschlussbereiche werden üblicherweise als Source und als Drain bezeichnet. Der Steuerbereich wird auch als Gate bezeichnet.

Die US 2002/0130354 A1 bzw. die US 4,996,574 betrifft einen Doppelgate FET in SOI-Technik mit einem Substratbereich, der nicht angeschlossen ist, so dass er auf unbestimmtem bzw. schwebenden Potential liegt. F. L. Duan et al, "Design analysis of novel mixed accumulation/inversion mode FD SOI MOS-FET", Proceedings 1997 IEEE International SOI Conference, Oct. 1997, Seiten 100/101, betrifft einen "Doppelgate ähnlichen" Transistor mit nicht angeschlossenem Substratbereich.

Die US 5,683,918 betrifft eine ESD-Schutzschaltung mit einem planaren FET mit einer einzigen ovalen Gateelektrode auf einem SOI-Substrat. Der Kanalbereich des FET's ist mit dem Sourceanschluss verbunden, so dass eine zusätzliche Diode gebildet wird, sogenanntes "body-tie". J. W. Sleight et al, "DC and transient characterization of compact Schottky body contact technology for SOI-transistors", IEEE Transactions on Electron Devices, Vol. 46, No. 7, July 1999, Seiten 1451 bis 1456, und J. M. Hwang et al, "Premature breakdown in nonfully depleted SOI/MOSFETS with body-tied-to-source structure", IEEE, 1991, Seiten 34/35, betreffen ebenfalls planare Transistoren.

L. J. McDaid et al, "Suppression of latch SOI MOSFET's by silicidation of Source", Electronics Letters, Vol. 27, No. 11, Seiten 1003 bis 1005, betrifft einen planaren Transistor.

Es ist Aufgabe der Erfindung, einen einfach aufgebauten Feldeffekttransistor anzugeben, der einen kleinen Flächenbedarf hat, für Schaltspannungen mit einem Betrag größer als fünf Volt oder größer als neun Volt geeignet ist und der hervorragende Kurzkanaleigenschaften hat, insbesondere einen hohen Drain-Strom und eine gute Sperreigenschaft. Außerdem sollen eine Verwendung für diesen Transistor und ein einfaches Verfahren zur Herstellung dieses Transistors angegeben werden.

Die auf den Transistor bezogene Aufgabe wird durch einen Feldeffekttransistor mit den im Patentanspruch 1 angegebenen Merkmalen gelöst. Weiterbildungen sind in den Unteransprüchen angegeben.

Der erfindungsgemäße Feldeffekttransistor enthält einen meist dotierten Substratbereich, der, bspw. vollständig oder zu mindestens fünfundsiebzig Prozent, von den folgenden Bereichen umgeben ist:
- zwei dotierten Anschlussbereichen,
- zwei elektrisch isolierenden Steuerbereich-Isolierschichten,
- und mindestens einem elektrisch isolierenden Bereich, dessen Dicke bei einer Ausgestaltung mindestens das doppelte oder mindestens das Zehnfache der Isolierdicke einer Steuerbereich-Isolierschicht beträgt.

Außerdem enthält der erfindungsgemäße Feldeffekttransistor einen elektrisch leitfähigen Verbindungsbereich zwischen dem einem Anschlussbereich und dem Substratbereich oder zwischen dem einem Anschlussbereich und einem zum Substratbereich führenden Bereich des gleichen Leitungstyps wie der Substratbereich.

Das Verwenden zweier Steuerbereiche führt zu einem kleinen Flächenbedarf und zu hervorragenden Kurzkanaleigenschaften. Das Umgeben des Steuerbereiches mit mindestens einem elektrisch isolierenden Bereich dient der Trennung des Substratbereiches von einem Hauptsubstrat einer integrierten Schaltungsanordnung, die den integrierten Feldeffekttransistor enthält. Durch die elektrisch leitfähige Verbindung zwischen dem Anschlussbereich und dem Substratbereich lässt sich das vom Hauptsubstrat getrennte Substrat ohne zusätzlichen Flächenbedarf für einen Substratanschluss so anschließen, dass störende Ladungsträger aus dem Substrat des Feldeffekttransistors effizient entfernt werden.

Das Verwenden eines durch mindestens einen Isolierbereich isolierten Substrates und der Anschluss des Substrates an den einen Anschlussbereich ermöglichen es, parasitäre Bipolareffekte ohne zusätzlichen Flächenbedarf für Anschlüsse des Substrates zu unterdrücken, so dass u.a. Schaltspannungen mit einem Betrag größer als fünf Volt oder größer als neun Volt geschaltet werden können. Beispielsweise werden der Substratbereich und der Source-Anschlussbereich auf gleichem Potential gehalten, wobei ein gemeinsamer Anschluss verwendet wird. Bei einer Ausgestaltung wird die Schottkybarriere zwischen dem Silizid und dem Substrat möglichst klein gehalten.

Bei einer Weiterbildung des erfindungsgemäßen Feldeffekttransistors enthält der leitfähige Verbindungsbereich ein Silizid oder besteht aus einem Silizid. Bei Ausgestaltungen werden Refraktärmetallsilizide oder Silizide mit Seltenerdmetallen eingesetzt. Die Verwendung von Siliziden bietet die Möglichkeit, den leitfähigen Verbindungsbereich mit Hilfe der sogenannten Salicid-Technik herzustellen (Self aligned Silicide). Bei dieser Technik wird das Silizid selektiv auf Silizium- oder Polysiliziumoberflächen erzeugt, nicht jedoch auf Siliziumdioxidoberflächen oder Oberflächen aus einem anderen Material. Durch diese Maßnahme muss beim Herstellen des leitfähigen Verbindungsbereiches kein zusätzliches Lithografieverfahren ausgeführt werden. Es lässt sich aber auch ein Lithografieverfahren ausführen, bei dem eine Maske erzeugt wird, die beispielsweise nur rechteckförmige Bereiche enthält. Die silizierten Bereiche haben auf Grund der Selektivität beim Salicide-Verfahren jedoch Strukturen, die von der Rechteckform abweichen. Als Silizid wird beispielsweise Kobaltsilizid, Platinsilizid, Erdiumsilizid oder Nickelsilizid verwendet.

Werden andere Halbleitermaterialien an Stelle von Silizium verwendet, z.B. Germanium, so werden dem Salicide-Verfahren ähnliche Verfahren genutzt, um selektiv Metall-Halbleiter-Verbindungen zu bilden.

Bei anderen Weiterbildungen wird ein leitfähiger Verbindungsbereich aus einkristallinem Silizium, aus polykristallinem Silizium oder aus einem Metall verwendet.

Bei einer nächsten Weiterbildung haben die einzelnen Elemente des Feldeffekttransistors Abmessungen und/oder Strukturen, die das Schalten von Spannungen größer als fünf Volt oder sogar größer als neun Volt oder größer fünfzehn Volt, jedoch vorzugsweise kleiner als dreißig Volt, zulassen:
- Isolierschichten zum Isolieren der Steuerbereiche vom Substratbereich haben eine Isolierschichtdicke von mindestens fünfzehn Nanometern oder von mindestens zwanzig Nanometern,
- der Abstand zwischen den Anschlussbereichen beträgt mindestens 0,3 Mikrometer oder mindestens 0,4 Mikrometer,
- die Anschlussbereiche haben im Vergleich zu den Dotierprofilen planarer Feldeffekttransistoren einen flachen Dotierprofilgradienten von beispielsweise etwa zweihundert Nanometern pro Dekade.

Die genannten Maßnahmen führen einzeln und insbesondere in Summe dazu, dass Spannungen mit einem Betrag größer als fünf Volt oder sogar größer als neun Volt geschaltet werden können.

Nach dem erfindungsgemäßen Feldeffekttransistor ist ein Isolierbereich des Feldeffekttransistors Bestandteil einer dritten Isolierschicht, die eine Vielzahl von Feldeffekttransistoren trägt. Die dritte Isolierschicht besteht bei einer Ausgestaltung aus Siliziumdioxid. Wird als Substratmaterial Silizium verwendet, so wird die Herstellungstechnik auch als SOI-Technik (Silicon On Insulator) bezeichnet.

Bei einer anderen Weiterbildung ist der Substratbereich einkristallin und gemäß einem Leitungstyp dotiert. Die Anschlussbereiche sind ebenfalls einkristallin, jedoch gemäß einem anderen Leitungstyp dotiert. Der Substratbereich ist homogen oder inhomogen dotiert.

Bei einer nächsten Weiterbildung des Feldeffekttransistors sind die Steuerbereiche elektrisch leitfähig miteinander verbunden, so dass ein sogenannter Double-Gate-Transistor entsteht, der hervorragende Kurzkanaleigenschaften hat.

Bei einer nächsten Weiterbildung des Feldeffekttransistors hat der Substratbereich sechs Seitenflächen, die quaderförmig oder pyramidenstumpfförmig zueinander angeordnet sind. Die Anschlussbereiche, die Isolierschichten zu den Steuerbereichen und die Isolierbereiche liegen jeweils an gegenüberliegenden Seiten des Substratbereiches.

Eine Ebene, welche die Anschlussbereiche und die Steuerbereiche enthält, liegt bei einer Ausgestaltung parallel zum Trägersubstrat. Beidseitig von dieser Ebene liegen die Isolierbereiche. In diesem Fall ist ein Isolierbereich Bestandteil eines SOI-Substrates.

Wird dagegen die Ebene, in der die Anschlussbereiche und die Steuerbereiche liegen, quer, z.B. im Winkel von neunzig Grad, zu einer Trägersubstratebene angeordnet, so wird zur Herstellung der Isolierbereiche beispielsweise eine Feldoxidtechnik oder eine STI-Technik eingesetzt (Shallow Trench Isolation). Auf Grund der verschiedenen Anordnungen der Ebene, in der die Anschlussbereiche und die Steuerbereiche liegen, entstehen Feldeffekttransistoren, deren Kanal quer (vertikal) zum Trägersubstrat oder parallel (horizontal) zum Trägersubstrat liegt.

Die Erfindung betrifft außerdem die Verwendung des erfindungsgemäßen Feldeffekttransistors gemäß den Ansprüchen 12 und 13.

Der die Verwendung des Feldeffekttransistors betreffende Aspekt der Erfindung geht von der Überlegung aus, dass von der bisher eingeschlagenen Richtung bei der Herstellung von Ansteuertransistoren für Speicherzellenfelder aus mehreren Gründen abgewichen werden sollte, um kleinere Speicherbausteine herstellen zu können:
- planare Feldeffekttransistoren zum Schalten von Schaltspannungen mit Beträgen größer als fünf Volt oder sogar größer als neun Volt lassen sich auf Grund physikalischer Grenzen nicht mehr verkleinern,
- selbst beim Verwenden der sogenannten split-voltage-Technik sind Programmierspannungen zu schalten, die betragsmäßig größer als fünf Volt oder sogar größer als neun Volt sind,
- eine Verringerung der Beträge der zu schaltenden Spannungen wäre mit einer Verringerung der Tunneloxiddicke verbunden. Die Verringerung dieser Dicke führt jedoch zu Zuverlässigkeitsproblemen, so dass dieser Weg mit vielen Schwierigkeiten verbunden ist.

Deshalb wird bei der erfindungsgemäßen Verwendung zur Ansteuerung des Speicherzellenfeldes ein Feldeffekttransistor eingesetzt, der den oben genannten Aufbau hat und deshalb auch die oben genannten Wirkungen zeigt, insbesondere das Schalten von Spannungen mit Beträgen größer als fünf Volt oder sogar größer als neun Volt ermöglicht, einen kleinen Flächenbedarf hat, hervorragende Kurzkanaleigenschaften besitzt und einfach herzustellen ist.

Die Erfindung betrifft außerdem ein Verfahren zum Herstellen eines Feldeffekttransistors gemäß Anspruch 14. Weiterbildungen sind in den unteransprüchen angegeben.

Auf Grund dieser Verfahrensweise gelten für das Verfahren die oben genannten technischen Wirkungen ebenfalls. Das Verfahren ist bei einer Weiterbildung besonders einfach, wenn der Verbindungsbereich mit einem Verfahren zum selektiven Aufbringen von Silizid hergestellt wird.

Im Folgenden werden Ausführungsbeispiele der Erfindung an Hand der beiliegenden Zeichnungen erläutert. Darin zeigen:
- Figur 1: einen integrierten Feldeffekttransistor mit zwei Steuerbereichen,
- Figur 2: eine Draufsicht auf den Feldeffekttransistor,
- Figur 3: eine Schnittdarstellung des Feldeffekttransistors in einer quer zur Kanalrichtung liegenden und einen Substratbereich enthaltenden Schnittebene,
- Figur 4: eine Schnittdarstellung des Feldeffekttransistors in einer quer zur Kanalrichtung liegenden und einen Sourcebereich enthaltenden Schnittebene,
- Figur 5: eine Schnittdarstellung des Feldeffekttransistors in einer längs zur Kanalrichtung liegenden und den Substratbereich enthaltenden Schnittebene,
- Figur 6: eine Schnittdarstellung des Feldeffekttransistors in einer längs zur Kanalrichtung liegenden und einen Steuerbereich enthaltenden Schnittebene,
- Figuren 7A bis 12B: Herstellungsstufen bei der Herstellung des Feldeffekttransistors,
- Figur 13: ein Ausführungsbeispiel des Feldeffekttransistors mit abschnittsweise dotiertem Verbindungsbereich,
- Figur 14: eine Darstellung des Feldverlaufs im Substratbereich des Feldeffekttransistors,
- Figur 15: ein Ausführungsbeispiel mit zwei parallel geschalteten Feldeffekttransistoren und selbstjustierenden Kontaktlöchern,
- Figur 16: ein Ausführungsbeispiel mit drei parallel geschalteten Feldeffekttransistoren und einer polykristallinen Verbindungsleitung, und
- Figur 17: die Verwendung des Feldeffekttransistors in einer Ansteuerschaltung für ein Speicherzellenfeld in einem EEPROM.

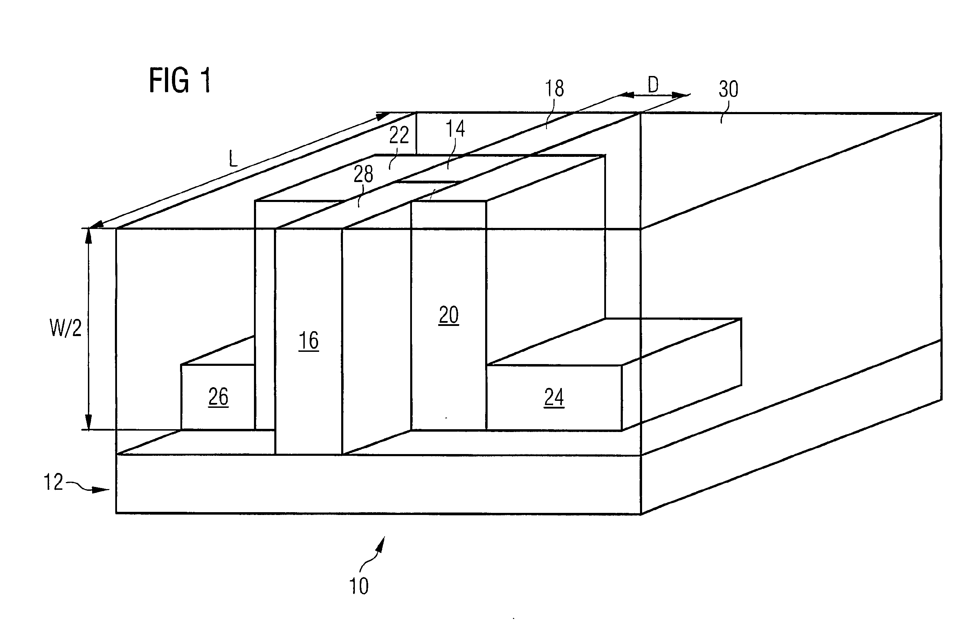

Figur 1 zeigt einen integrierten Feldeffekttransistor 10, der sich auf einer Isolierschicht 12 befindet. Die Isolierschicht 12 besteht beispielsweise aus Siliziumdioxid und ist Bestandteil eines Hauptsubstrates, das eine Vielzahl von integrierten Feldeffekttransistoren 10 in einer integrierten Schaltung trägt.

Der Feldeffekttransistor 10 enthält einen quaderförmigen Substratbereich 14, der im Ausführungsbeispiel p-dotiert ist. Bei einem anderen Ausführungsbeispiel ist der Substratbereich 14 n-dotiert, so dass ein p-Kanal-Anreicherungstransistor entsteht.

Der quaderförmige Substratbereich 14 hat eine Höhe, die etwa der halben Kanalweite W des Feldeffekttransistors 10 entspricht. Eine Länge L des quaderförmigen Substratbereiches 14 entspricht einer Kanallänge. Der quaderförmige Substratbereich 14 hat eine Dicke D, die etwa einem Drittel der Länge L entspricht.

An den langen Schmalseiten des quaderförmigen Substratbereiches 14 sind ein Sourcebereich 16 und ein Drainbereich 18 angeordnet, die beide n-dotiert sind. An den einander gegenüberliegenden breiten Seitenflächen des Substratbereiches 14 befinden sich Gatebereiche 20 und 22, die aus dotiertem Polysilizium bestehen und vom Substratbereich 14 durch eine in Figur 1 nicht dargestellte Gateoxidschicht mit einer Dicke von beispielsweise fünfzehn Nanometern getrennt sind. An den Gatebereich 20 bzw. 22 schließt sich ein Polybereich 24 bzw. 26 aus ebenfalls dotiertem polykristallinen Silizium an.

Die kurzen Schmalseiten des Substratbereiches 14 grenzen im Fall der Bodenfläche des quaderförmigen Substratbereiches 14 an die Isolierschicht 12 und im Fall der Deckfläche des Substratbereiches 14 an eine nicht dargestellte Isolierschicht an. Ein Teil der Deckfläche wird von einem Verbindungsbereich 28 bedeckt, der sich weiter über die Deckfläche des Sourcebereiches 16 erstreckt und damit eine elektrisch leitfähige Verbindung zwischen dem Substratbereich 14 und dem Sourcebereich 16 herstellt. Der Verbindungsbereich 28 besteht aus einem Silizid.

Somit ist der Substratbereich 14 vollständig durch den Sourcebereich 16, den Drainbereich 18, den Gatebereich 20, den Gatebereich 22, die Isolierschicht 12 und die nicht dargestellte obere isolierende Schicht sowie durch einen Teil des Verbindungsbereiches 28 umschlossen. Der Feldeffekttransistor 10 wird durch ein Fülloxid 30 eingeschlossen, beispielsweise durch Siliziumdioxid.

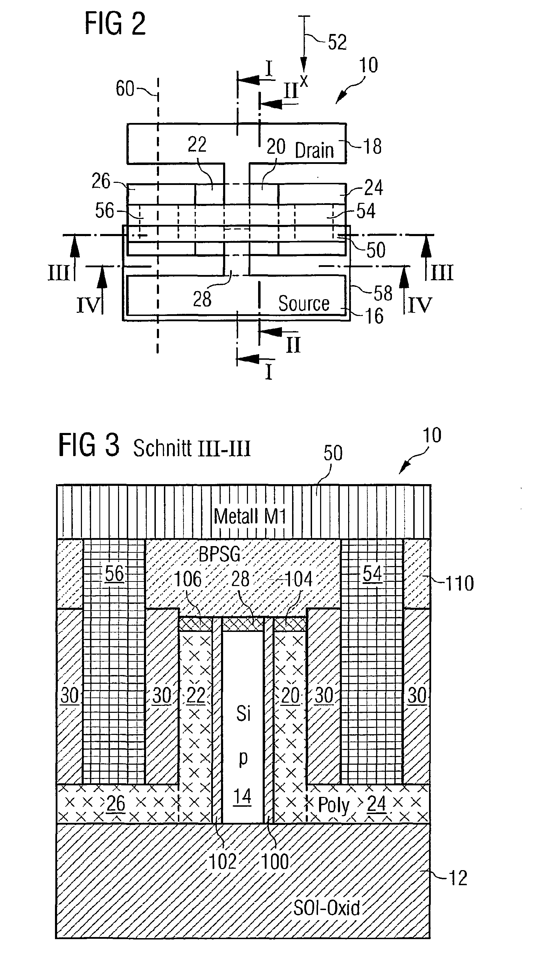

Figur 2 zeigt eine Draufsicht auf den Feldeffekttransistor 10. Neben den bereits an Hand der Figur 1 erläuterten Bereichen ist eine Metallleitbahn 50 dargestellt, deren Längsachse sich im rechten Winkel zu einer durch einen Richtungspfeil 52 dargestellten Kanalrichtung erstreckt. Von der Metallleitbahn 50 führen sich durch das Fülloxid 30 erstreckende Verbindungsabschnitte 54 bzw. 56 zu den Polybereichen 24 bzw. 26. Das Fülloxid 30 ist in Figur 2 aus Gründen der besseren Übersichtlichkeit nicht dargestellt.

In Figur 2 sind außerdem die Lagen von Schnittebenen III, IV, I und II dargestellt, deren zugehörige Schnittdarstellungen unten an Hand der Figuren 3, 4, 5 und 6 näher erläutert werden. In Figur 2 ist weiterhin ein rechteckförmiges Maskenfenster 58 dargestellt, das den T-förmigen Sourcebereich 16 umschließt. Das Maskenfenster 58 dient zum selektiven Erzeugen des Salicides im Verbindungsbereich 28 und auch auf der übrigen Deckfläche des Sourcebereiches 16.

Bei einem anderen Ausführungsbeispiel sind mindestens zwei Feldeffekttransistoren 10 parallel geschaltet. Für diesen Fall ist die in Figur 2 gezeigte Struktur entlang einer gestrichelten Linie 60 nach links zu spiegeln. Das bedeutet unter anderem, dass der Sourcebereich 16 und der Drainbereich 18 nach links zum nächsten Feld des Feldeffekttransistors durchgehend ausgebildet sind. Das Maskenfenster 58 erstreckt sich bei diesem Ausführungsbeispiel über den erweiterten Sourcebereich 16.

Figur 3 zeigt eine Schnittdarstellung des Feldeffekttransistors 10 in der Schnittebene III. Bereiche aus Siliziumdioxid sind in den Figuren mit Geraden schraffiert. Dies betrifft in Figur 3 die Isolierschicht 12, das Fülloxid 30 sowie Gateoxidbereiche 100 und 102.

Bereiche aus einkristallinem Silizium sind in den Figuren weiß, siehe beispielsweise den Substratbereich 14 in Figur 3. Polykristalline Bereiche sind mit Kreuzen bedeckt, siehe beispielsweise die Gatebereiche 20 und 22 sowie die Polybereiche 24 und 26 in Figur 3. Bereiche aus Metall sind vertikal schraffiert, siehe beispielsweise die Metallleitbahn 50, die beispielsweise aus Kupfer oder Aluminium besteht.

Bereiche, in denen sich Refraktärmetalle befinden, sind durch Bereiche mit horizontal und vertikal verlaufenden Gitternetzlinien dargestellt, siehe beispielsweise die Verbindungsabschnitte 54 und 56. Bereiche, in denen sich Silizide befinden, sind in den Figuren mit schräg verlaufenden Gitternetzlinien dargestellt. Dies trifft in Figur 3 für den Verbindungsbereich 28 sowie für Salicidbereiche 104 und 106 zu, die sich auf in dem Sourcebereich 16 nahen Bereichen der Gatebereiche 20 und 22 befinden.

Schließlich sind Bereiche, in denen sich im Ausführungsbeispiel ein Bor-Phosphor-Silikatglas (BPSG) befindet, mit gestrichelten Linien schraffiert, siehe beispielsweise einen Isolierbereich 110 zwischen der Metallleitbahn 50 und dem Füllbereich 30.

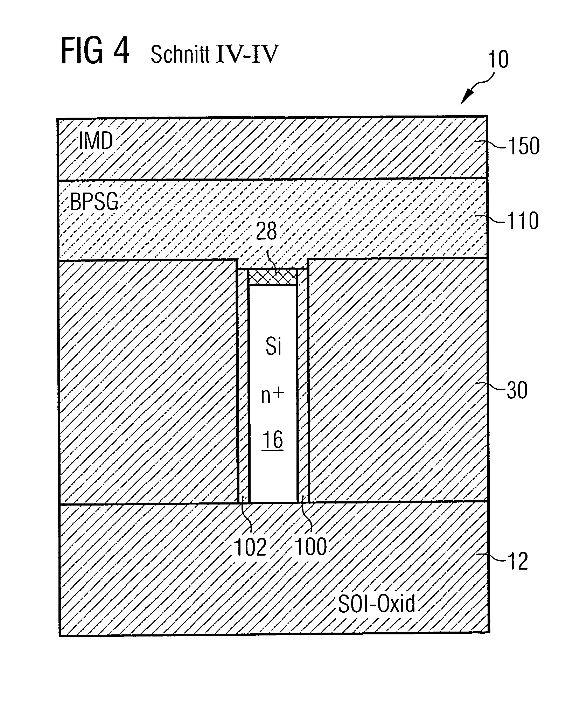

Figur 4 zeigt eine Schnittdarstellung des Feldeffekttransistors 10 entlang der Schnittebene IV. Wie in Figur 4 zu erkennen ist, erstreckt sich das Oxid der Gateoxidbereiche 100 bzw. 102 auch entlang des Sourcebereiches 16. In der Schnittebene IV ist die Silikatglasschicht 110 mit einem Intermetalldielektrikum 150 belegt, das im Ausführungsbeispiel aus Siliziumdioxid besteht. Bereiche neben dem Verbindungsbereich 28 sind in der Schnittebene IV nicht mit Silizid bedeckt, da sich in der Schnittebene IV auf der Höhe des Verbindungsbereiches 28 an das Gateoxid 100 bzw. 102 Siliziumdioxid des Füllbereiches 30 anschließt.

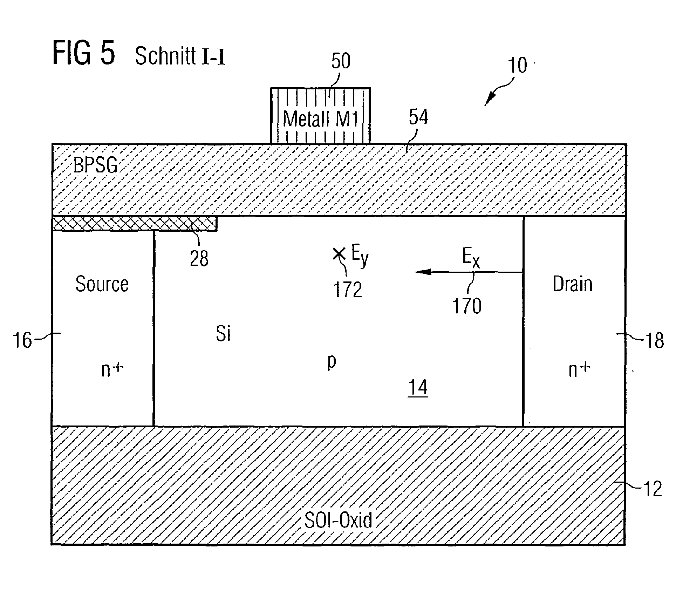

Figur 5 zeigt eine Schnittdarstellung des Feldeffekttransistors 10 entlang des Schnittes I. In Figur 5 sind außerdem eine x-Komponente 170 des elektrischen Feldes und eine y-Komponente 172 des elektrischen Feldes im Substratbereich 14 dargestellt. Die x-Komponente 170 zeigt vom Drainbereich 18 zum Sourcebereich 16. Die y-Komponente 172 zeigt in die Zeichenebene hinein vom Gatebereich 20 zum Gatebereich 22.

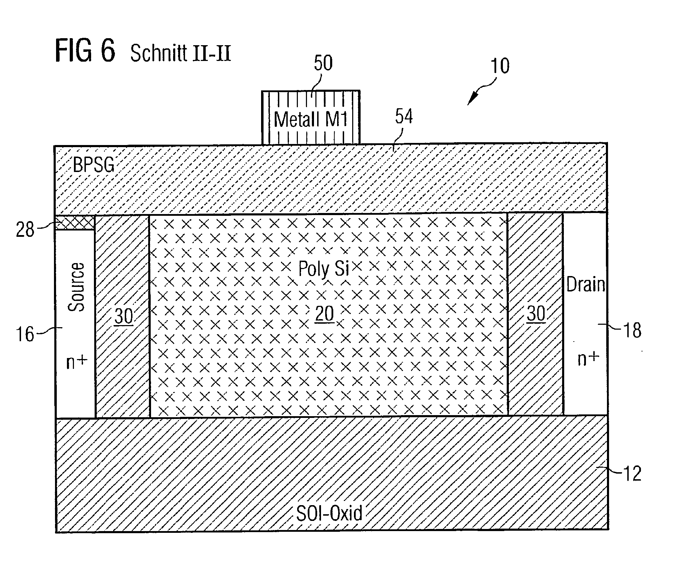

Figur 6 zeigt eine Schnittdarstellung des Feldeffekttransistors 10 in der Schnittebene II. Gut zu erkennen ist, dass sich der Verbindungsbereich 28 auch oberhalb desjenigen Bereiches des Sourcebereiches 16 befindet, der nicht direkt zum Substratbereich 14 führt.

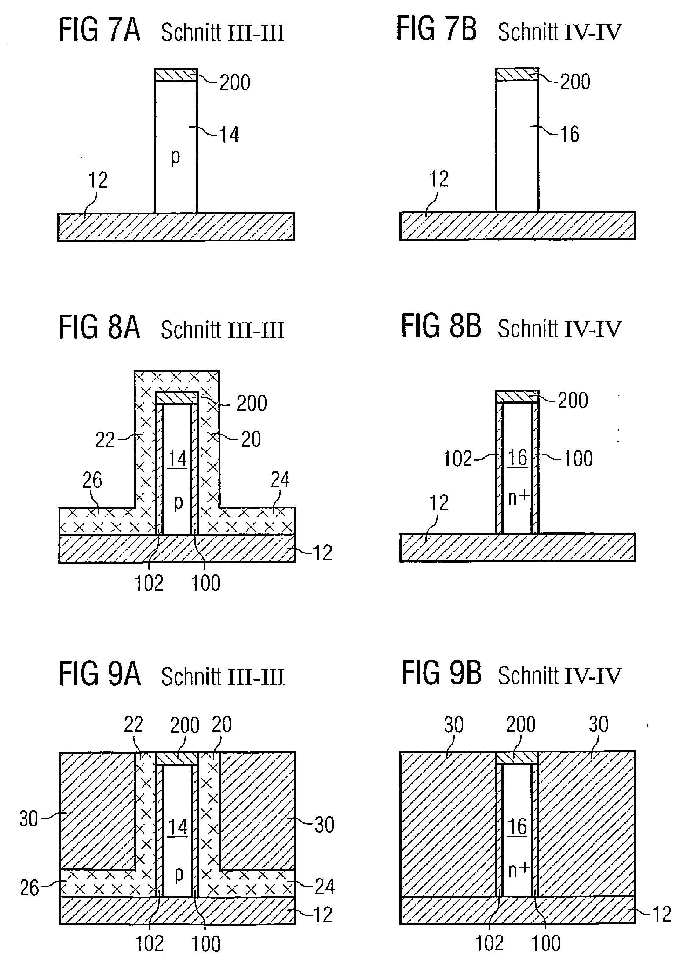

Figuren 7A und 7B zeigen eine erste Herstellungsstufe bei der Herstellung des Feldeffekttransistors 10. Die Herstellung beginnt ausgehend von einem SOI-Substrat (Silicon On Insulator), bei dem eine sich auf der Isolierschicht 12 befindende Siliziumschicht im Ausführungsbeispiel eine Dicke von einhundert Nanometern hat und bereits p-dotiert ist. Auf der Siliziumschicht wird eine sogenannte Hartmaske aus Siliziumnitrid 200 hergestellt. Dazu wird das Siliziumnitrid 200 ganzflächig erzeugt. Die Schicht aus Siliziumnitrid 200 wird dann mit Hilfe eines fotolithografischen Verfahrens strukturiert und oberhalb der Bereiche, in denen sich später der Füllbereich 30 befindet, geöffnet. Anschließend wird ein reaktives Ionenätzen durchgeführt, das auf der Isolierschicht 12 stoppt. Auf der Isolierschicht 12 verbleiben der Substratbereich 14, siehe Schnitt III, und der Sourcebereich 16, siehe Schnitt IV, sowie der Drainbereich 18.

Wie in den Figuren 8A und 8B für den Schnitt III bzw. den Schnitt IV dargestellt, werden anschließend die Gateoxidbereiche 100 und 102 hergestellt, beispielsweise mit Hilfe einer thermischen Oxidation. Das Oxid der Gateoxidbereiche 100 bzw. 102 erstreckt sich nicht nur am Substratbereiches 14 entlang, sondern auch am Sourcebereich 16 bzw. am Drainbereich 18 entlang.

Anschließend wird eine Schicht aus polykristallinem Silizium abgeschieden und mit Hilfe eines fotolithografischen Verfahrens strukturiert. Beim Strukturieren werden die Gatebereiche 20 und 22 und die Polybereiche 24 und 26 erzeugt, siehe Schnitt III. Im Bereich des Schnittes IV wird dagegen das Polysilizium bei der Strukturierung wieder entfernt.

Nach dem Strukturieren des Polysiliziums wird eine Schrägimplantation von LDD-Bereichen (Lightly Doped Drain) durchgeführt. Anschließend werden der Sourcebereich 16 und der Drainbereich 18 mit Hilfe einer Ionenimplantation dotiert, z.B. stark n-dotiert, d.h. n+. Gleichzeitig werden die polykristallinen Gatebereiche 20 und 22 und die Polybereiche 24 und 26 dotiert.

Wie in den Figuren 9A und 9B dargestellt, wird nach dem Implantieren im Füllbereich 30 Siliziumdioxid abgeschieden. Damit sind die Zwischenräume zwischen verschiedenen Substratbereichen 14 und verschiedenen Drainbereichen 16 bzw. 18 ausgefüllt. Nach dem Füllen der Füllbereiche 30 wird ein chemisch-mechanisches Polierverfahren (CMP) durchgeführt, das auf dem Siliziumnitrid 200 stoppt. Durch das CMP-Verfahren wird wieder eine ebene Oberfläche erzeugt.

Anschließend wird mit Hilfe eines Trockenätzprozesses das polykristalline Silizium etwas zurückgeätzt, bis es die gleiche Höhe wie der Substratbereich 14 hat. Durch diesen Rückätzschritt wird für das folgende Aufbringen der Silizidschicht im Bereich des Substratbereiches 14 ein gleiches Höhenniveau geschaffen.

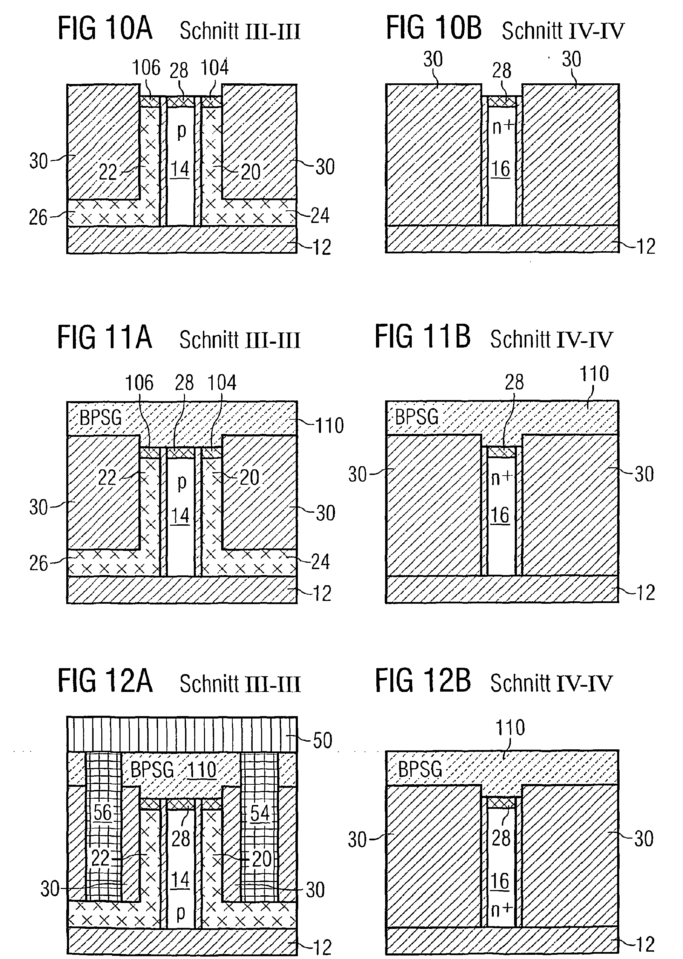

Wie in den Figuren 10A und 10B gezeigt, wird danach das Siliziumnitrid 200 oberhalb des Sourcebereiches 16 und oberhalb des Bereiches des Substratbereiches 14 entfernt, über dem später der Verbindungsabschnitt 28 angeordnet wird. Dafür wird eine Fotolackschicht aufgebracht und mit Hilfe eines fotolithografischen Verfahrens strukturiert, wobei das in Figur 2 dargestellte Maskenfenster 58 oberhalb des Sourcebereiches 16 und auch oberhalb des sourceseitigen Polybereiches 20 bis 26 entsteht. Innerhalb des Maskenfensters 58 wird danach das Siliziumnitrid 200 entfernt. Danach wird die das Maskenfenster 58 enthaltene Fotolackschicht entfernt.

Anschließend wird ganzflächig bspw. Nickel aufgebracht, das bei einem Temperschritt bei bspw. 500 Grad Celsius eine Silizidverbindung oberhalb von Bereichen bildet, die aus Silizium bestehen, d.h. oberhalb des Substratbereiches 14, des Sourcebereiches 16, des Gatebereiches 20 und des Gatebereiches 22. Es entstehen der Verbindungsbereich 28 auf dem freiliegenden Teil des Substratbereiches 14 und die Silizidbereiche 104 und 106 auf den Gatebereichen 20 bzw. 22.

Anschließend wird das Nickel in Bereichen entfernt, in denen sich kein Silizid gebildet hat. Beispielsweise wird das Nickel mit einem nasschemischen Ätzprozess entfernt.

Wie in den Figuren 11A und 11B dargestellt, wird anschließend das Silikatglas 110 ganzflächig aufgebracht. Beispielsweise wird das Silikatglas 110 aufgeschleudert.

Wie in den Figuren 12A und 12B dargestellt, werden danach die Verbindungsabschnitte 54 und 56 hergestellt. Dazu wird ein fotolithografisches Verfahren ausgeführt, um im Silikatglas 110 Kontaktlöcher zu erzeugen, welche die Verbindungsabschnitte 54 und 56 aufnehmen sollen. Die Kontaktlöcher werden dann z.B. mit Wolfram gefüllt, um die Verbindungsabschnitte 54 und 56 zu bilden. Wie in Figur 12A gezeigt, werden die Kontaktlöcher so erzeugt, dass zwischen dem Verbindungsabschnitt 54 und dem Gatebereich 20 Füllmaterial 30 verbleibt. Auch zwischen dem Verbindungsabschnitt 56 und dem Gatebereich 22 verbleibt Füllmaterial 30.

Danach wird die Metallleitbahn 50 erzeugt, die zu den Verbindungsabschnitten 54 und 56 führt. Beispielsweise enthält die Metallleitbahn 50 als Hauptbestandteil Aluminium. In diesem Fall wird Aluminium ganzflächig aufgebracht und anschließend mit Hilfe eines fotolithografischen Verfahrens strukturiert. Dabei wird die Metallschicht u.a. oberhalb des Silikatglases 110 entlang der Schnittebene IV wieder entfernt.

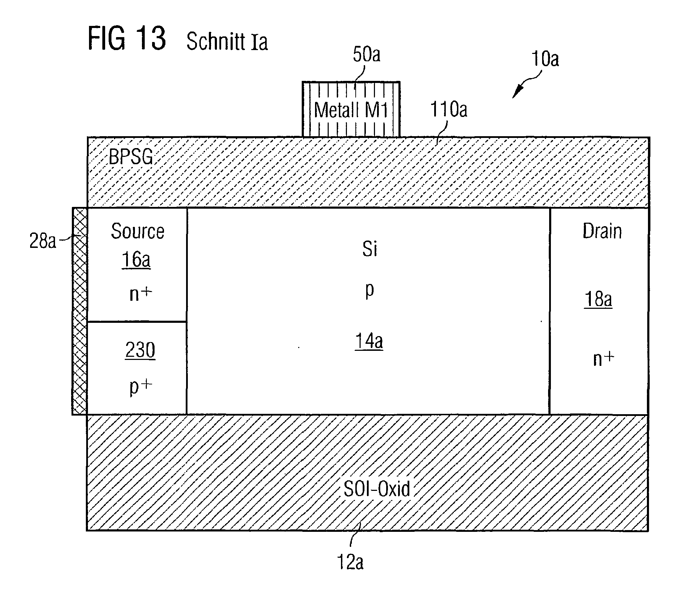

Figur 13 zeigt ein Ausführungsbeispiel eines Feldeffekttransistors 10a entlang eines Schnittes Ia, dessen Lage der Lage des Schnittes I entspricht. Der Feldeffekttransistor 10a enthält wie der Feldeffekttransistor 10 eine Isolierschicht 12a, einen Substratbereich 14a, einen Sourcebereich 16a, einen Drainbereich 18a und einen Verbindungsbereich 28a. Der Feldeffekttransistor 10a ist von einem Silikatglas 110a bedeckt, z.B. von Bor-Phosphor-Silikatglas (BPSG), das zur Isolierung von einer Metallleitbahn 50a dient.

Im Gegensatz zum Feldeffekttransistor 10 liegt der Verbindungsbereich 28a quer zu einem sich beim Betrieb des Feldeffekttransistors 10a ausbildenden Kanal. Der Sourcebereich 16a ist nur etwa halb so tief wie der Sourcebereich 16. Zwischen dem Sourcebereich 16a und dem Isolierbereich 12a befindet sich ein p-dotierter Bereich 230, d.h. ein Bereich mit einer Dotierung des gleichen Leitungstyps wie der Substratbereich 14a. Der Verbindungsbereich 28a verbindet den Sourcebereich 16a und den Bereich 230. Der Substratbereich 14a ist damit über den Bereich 230 mit dem Verbindungsbereich 28a verbunden.

Der Verbindungsbereich 28a lässt sich wiederum mit Siliziden unter Verwendung der Salicide-Technik herstellen. Jedoch werden bei einem anderen Ausführungsbeispiel Metalle zur Herstellung des Verbindungsbereiches 28a verwendet.

Bei einem anderen Ausführungsbeispiel sind der Sourcebereich 16a und der Bereich 230 vertauscht. Nur der Bereich 230 wird in diesem Fall mit einem Kontakt kontaktiert.

Bei einem weiteren Ausführungsbeispiel des in Figur 13 dargestellten Transistors wird das polykristalline Silizium oberhalb des Substratbereiches 16a nicht entfernt, so dass den Gatebereichen 20, 22 entsprechende Gatebereiche über das dotierte polykristalline Silizium elektrisch leitend miteinander verbunden sind.

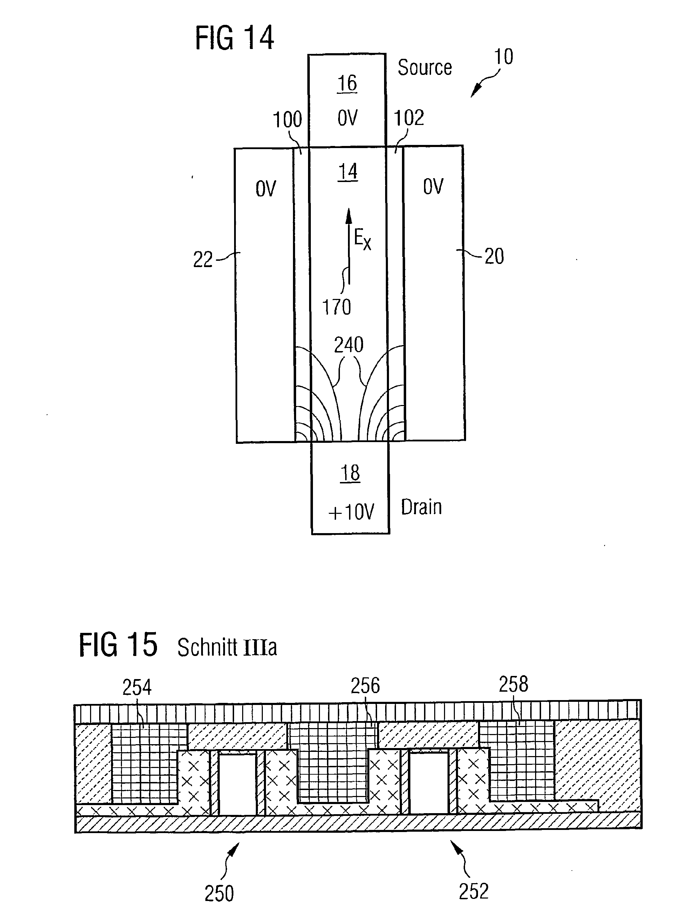

Figur 14 zeigt eine Darstellung des Feldverlaufes im Substratbereich 14 bzw. auch im Substratbereich 14a. Es sei angenommen, dass der Sourcebereich 16, der Gatebereich 20 und der Gatebereich 22 auf ein Potential von null Volt gelegt werden. Der Drainbereich 18 wird auf ein Potential von zehn Volt gelegt. Für diese Potentialverteilung bilden sich die in Figur 14 dargestellten Feldlinien 240 aus.

Auf Grund der Verwendung der SOI-Technik und auf Grund des Anschlusses des Substrates 14 ergeben sich für den sogenannten GIDL (Gate Induced Drain Leakage) die folgenden Verhältnisse:
- ohne Verwendung von zwei Gatebereichen 20, 22 enden fast alle Feldlinien auf einer Gateseite. Bei der Verwendung von zwei Gatebereichen 20 bis 22 ergibt sich eine geringere Feldliniendichte, die zu einer verbesserten Durchbruchs-Festigkeit des Feldeffekttransistors 10 führt.
- Außerdem wird die in x-Richtung gerichtete Feldkomponente 170 kleiner, so dass auch deshalb die Durchbruchsspannung steigt.
- Quer zur Komponente 170 gerichtete y-Komponenten lenken die Ladungsträger zum Gateoxidbereich 100 bzw. 102. Dadurch treffen die meisten Ladungsträger auf den Gatebereich 20, 22 auf, bevor sie eine lawinenartige Stoßionisation verursachen. Der gate-gesteuerte Durchbruch wird reduziert, weil die Elektron/Loch-Erzeugung durch Stoßionisation stark reduziert ist. Die meisten Ladungsträger werden auf Grund der gekrümmten Feldlinien zum Gateoxid 100 bzw. 102 abgelenkt, bevor sie genügend Energie für eine Stoßionisation aufnehmen können. Das bedeutet mit anderen Worten, dass die mittlere freie Weglänge bis zu einer Stoßionisation größer als der Weg zum Gateoxid 100 bzw. 102 ist. Für lange Wegstrecken einiger weniger Ladungsträger bis zum Gateoxid 100 bzw. 102 geben die Ladungsträger dagegen Energie durch Phononenstreuung ab, so dass sie ebenfalls nicht ausreichend Energie für eine Stoßionisation aufnehmen können. Auf Grund der geringen Anzahl von Ladungsträgern mit langen Wegstrecken kann das Substrat die durch die Phononenstreuung entstehende Energie aufnehmen ohne dass es zu einer Stoßionisation kommt. Somit können auch Spannungen größer als fünf Volt und sogar größer als neun Volt geschaltet werden.

Die längsten Abstände zwischen Substratbereich 14 bzw. 14a und Verbindungsabschnitt 28 bzw. Bereich 230 sind so kurz gewählt, dass die generierten Ladungsträger sehr schnell zum Verbindungsabschnitt 28 bzw. zum Bereich 230 driften können und so eine Überflutung des Substrates 14 bzw. 14a mit Ladungsträgern verhindert wird. Durch die genannten Maßnahmen werden die Hochspannungseigenschaften des Feldeffekttransistors 10 bzw. 10a im Vergleich zu bekannten Feldeffekttransistoren erheblich verbessert.

Figur 15 zeigt ein Ausführungsbeispiel mit zwei parallel geschalteten Feldeffekttransistoren 250 und 252, die im Wesentlichen jeweils wie der Feldeffekttransistor 10 aufgebaut sind. Figur 15 zeigt die Feldeffekttransistoren 250 und 252 entlang eines Schnittes IIIa, dessen Lage der Lage des Schnittes III entspricht.

Jedoch wurden Kontaktlöcher für Verbindungsabschnitte 254, 256 und 258 selbstjustierend zum Polysilizium der Gatebereiche und Polybereiche hergestellt. Das bedeutet, dass zwischen den Verbindungsabschnitten 254, 256 und 258 und dem polykristallinen Silizium kein Füllmaterial 30 verbleibt.

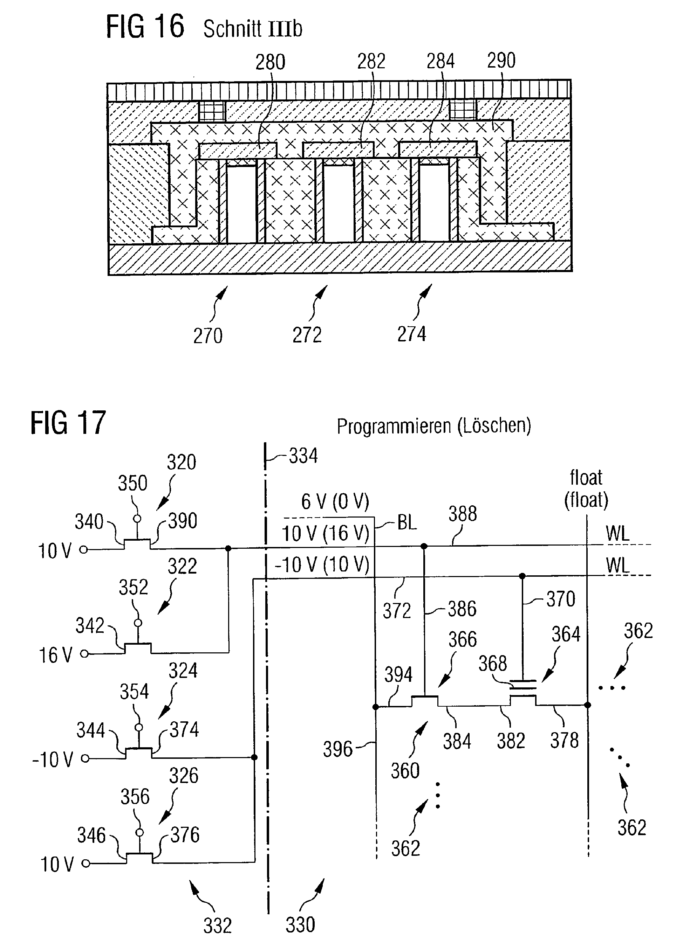

Figur 16 zeigt ein Ausführungsbeispiel mit drei parallel geschalteten Feldeffekttransistoren 270, 272 und 274, die im Wesentlichen jeweils wie der Feldeffekttransistor 10 aufgebaut sind. Figur 16 zeigt die Feldeffekttransistoren 270 bis 274 entlang eines Schnittes IIIb, dessen Lage der Lage des Schnittes III entspricht.

Zwischen den einzelnen Gatebereichen der Feldeffekttransistoren 270, 272 und 274 befinden sich weder Füllmaterial 30 noch Verbindungsabschnitte sondern nur polykristallines Silizium. Jedoch befinden sich oberhalb der Substratbereiche der Feldeffekttransistoren 270 bis 274 Füllbereiche 280, 282 bzw. 284 aus Siliziumdioxid. Die Füllbereiche 280 bis 284 sind so strukturiert, dass darüberliegendes polykristallines Silizium 290 die polykristalline Bereiche zwischen den Feldeffekttransistoren 270 bis 274 und an den Rändern der Feldeffekttransistoren 270 bis 274 verbindet.

Figur 17 zeigt den Einsatz von vier Feldeffekttransistoren 320 bis 326, die wie der Feldeffekttransistor 10 aufgebaut sind, als Ansteuertransistoren für ein Speicherzellenfeld 330 in einem EEPROM. Die Feldeffekttransistoren 320 bis 326 sind Bestandteil einer Ansteuereinheit 332, die von dem Speicherzellenfeld 330 in Figur 17 durch eine gestrichelte Linie 334 getrennt ist. Die Ansteuereinheit 332 steuert das Speicherzellenfeld 330 beispielsweise nach dem sogenannten NOR-Verfahren oder nach dem NAND-Verfahren an.

Die Feldeffekttransistoren 320 bis 326 wurden mit einem Verfahren hergestellt, wie es oben an Hand der Figuren 7A bis 12B erläutert worden ist. Anschlüsse 340, 342, 344 und 346 der Feldeffekttransistoren 320, 322, 324 bzw. 326 liegen in dieser Reihenfolge auf Potentialen von plus zehn Volt, plus sechzehn Volt, minus zehn Volt bzw. plus zehn Volt. Gate-Anschlüsse 350 bis 356 der Feldeffekttransistoren 320 bis 326 werden durch eine nicht dargestellte Steuereinheit angesteuert, um Speicherzellen des Speicherzellenfeldes 330 u.a. gemäß einem Programmierverfahren bzw. gemäß einem Löschverfahren anzusteuern. Die Ansteuerverfahren sind jedoch nicht Gegenstand der vorliegenden Anmeldung und werden deshalb nicht näher erläutert.

In Figur 17 ist außerdem eine Prinzipschaltung für eine Speicherzelle 360 des Speicherzellenfeldes 330 angegeben. Weitere Speicherzellen 362 einer Speichermatrix sind durch Pfeile angedeutet. Die anderen Speicherzellen des Speicherzellenfeldes 330 sind wie die Speicherzelle 360 aufgebaut.

Die Speicherzelle 360 enthält einen Speichertransistor 364 und einen Auswahltransistor 366. Der Speichertransistor 364 ist ein Feldeffekttransistor mit einer ladungsspeichernden Zwischenschicht 368 zwischen einem Gate-Anschluss 370 und einem Kanalbereich. Der Gate-Anschluss 370 ist mit einer Wortleitung 372 verbunden, die zu einem Anschluss 374 des Transistors 324 und zu einem Anschluss 376 des Transistors 326 führt. An der Wortleitung 372 liegt beim Programmieren eine Spannung von minus zehn Volt und beim Löschen eine Spannung von plus zehn Volt an. Ein Anschluss 378 des Transistors 364 führt zu einer Hilfsleitung 380, deren Potential auf das Programmieren und Löschen der Speicherzelle 360 keinen Einfluss hat. Ein Anschluss 382 des Transistors 364 ist mit einem Anschluss 384 des Feldeffekttransistors 366 verbunden. Ein Gate-Anschluss 386 des Auswahltransistors 366 führt zu einer weiteren Wortleitung 388, die mit einem Anschluss 390 des Transistors 320 und mit einem Anschluss 392 des Feldeffekttransistors 322 verbunden ist. An der Wortleitung 388 liegt beim Programmieren eine Spannung von plus zehn Volt und beim Löschen eine Spannung von plus sechszehn Volt an.

Ein Anschluss 394 des Feldeffekttransistors 366 wird mit einer Bitleitung 396 verbunden, an die durch die Ansteuereinheit 332 beim Programmieren eine Spannung von sechs Volt und beim Löschen der Speicherzelle 360 eine Spannung von null Volt angelegt wird.

Die an Hand der Figur 17 erläuterten Speicherzellen sind Speicherzellen eines EEPROM. Bei sogenannten Flash-Speicherbausteinen gibt es in einer Speicherzelle 360 nur einen Speichertransistor. Ein Auswahltransistor 366 ist nicht erforderlich. Bei einem anderen Ausführungsbeispiel sind der Speichertransistor 364 und der Ansteuertransistor 366 in einem Transistor realisiert, d.h. in einem sogenannten splitgate-Transistor.

Allen genannten Speicherzellstrukturen ist jedoch gemeinsam, dass betragsmäßig vergleichsweise hohe Löschspannungen und Programmierspannungen erforderlich sind, die mit Hilfe der erfindungsgemäßen Feldeffekttransistoren 320 bis 326 erzeugt werden. Durch die Verwendung der Feldeffekttransistoren 320 bis 326 lässt sich die Ansteuereinheit 332 mit zunehmendem Integrationsgrad auf gleiche Weise verkleinern, wie das Speicherzellenfeld 330.

Es werden sowohl N-Kanal-Feldeffekttransistoren als auch P-Kanal-Feldeffekttransistoren hergestellt. Außerdem lassen sich beliebig viele Feldeffekttransistoren mit jeweils zwei Steuerbereichen parallel schalten. Die Stromergiebigkeit steigt mit der Anzahl der parallel geschalteten Transistoren. Bei herkömmlichen Transistoren wird dies durch eine größere Weite des Kanals erzielt.

Die Einsatzspannung Vt der Feldeffekttransistoren kann durch die Dotierung im Kanal und über die Dicke D des Siliziums zwischen den beiden Gatebereichen eingestellt werden. Bei den oben erläuterten Transistoren ist die Einstellung der Einsatzspannung unproblematisch, weil die Einsatzspannung Vt nicht über die Gateoxiddicke, die Austrittsarbeit des Gatematerials oder die SOI-Oxiddicke vorgegeben werden muss.

Die Stromergiebigkeit der erläuterten Transistoren wird auch durch die Höhe der Siliziumschicht vorgegeben. Rein rechnerisch ist die Kanalweite W eines Transistors gleich der doppelten Siliziumhöhe. Da Doppel-Gate-Transistoren jedoch eine wesentlich bessere Stromergiebigkeit haben, z.B. um den Faktor Zwei höher als planare Transistoren, kann die benötigte Anzahl von parallel geschalteten Transistoren deutlich kleiner sein, als es sich aus rein geometrischen Überlegungen ergeben würde. Für die meisten Anwendungen sind deshalb Einzeltransistoren ausreichend.

Bei einem anderen Ausführungsbeispiel gibt es zusätzlich zum Maskenfenster 58 auch ein Maskenfenster zum Silizidieren des Drainbereiches 18. Der Sourcebereich 16 und der Drainbereich 18 werden an ihrer Deckfläche möglichst vollständig mit Silizid bedeckt, um den Kontaktwiderstand und den Schichtwiderstand zu verringern.

Bei allen erläuterten Ausführungsbeispielen werden die Sourcebereiche 16 und die Drainbereiche 18 selbstverständlich ebenfalls kontaktiert, bspw. mit Wolframkontakten, die sich durch das Silikatglas 110 erstrecken und die in Metallisierungslagen mit Leitbahnen elektrisch leitfähig verbunden sind.

## Patentansprüche

1. Integrierter Feldeffekttransistor (10),
mit einem Substratbereich (14), der umgeben ist:
von zwei an einander gegenüberliegenden Seiten des Substratbereiches (14) angeordneten Anschlussbereichen (16, 18), wobei der eine Anschlussbereich (16, 18) ein Sourcebereich (16) und der andere Anschlussbereich (16, 18) ein Drainbereich (18) ist,
von zwei an einander gegenüberliegenden Seiten des Substratbereiches (14) angeordneten elektrisch isolierenden Isolierschichten (100, 102), an denen Steuerbereiche (20, 22) angrenzen,
von zwei elektrisch isolierenden Isolierbereichen (12, 110), wobei die Isolierbereiche (12, 110) an einander gegenüberliegenden Seiten des Substratbereiches (14) angeordnet sind,
und wobei ein Isolierbereich (12) am Boden des Substratbereichs (14) Bestandteil einer dritten Isolierschicht ist, die eine Vielzahl von Feldeffekttransistoren (10) trägt,
und von einem elektrisch leitfähigen Verbindungsbereich (28) oder einem Teil (230) eines elektrisch leitfähigen Verbindungsbereiches, der eine elektrisch leitfähige Verbindung zwischen dem einem Anschlussbereich (16) und dem Substratbereich (14) herstellt,
wobei der leitfähige Verbindungsbereich (28) eine Metall-Halbleiter-Verbindung enthält oder aus einer Metall-Halbleiter-Verbindung besteht,
wobei ein Teil einer Deckfläche des Substratbereiches (14) von dem Verbindungsbereich (28) bedeckt wird, wobei sich der Verbindungsbereich (28) weiter über eine Deckfläche des Sourcebereiches (16) erstreckt,
und wobei der Teil der Deckfläche des Substratbereiches (14) den Substratbereich (14) zwischen den zwei Isolierschichten (100, 102) und zwischen den beiden Steuerbereichen (20, 22) bedeckt.

2. Feldeffekttransistor (10) nach Anspruch 1, **dadurch gekennzeichnet, dass** der leitfähige Verbindungsbereich (28) aus einem Silizid eines Metalls mit einer Schmelztemperatur größer als 1400 Grad Celsius und/oder einem Refraktärmetallsilizid oder einem Seltenerdmetallsilizid besteht.

3. Feldeffekttransistor (10) nach Anspruch 1 oder 2, **da** - **durch gekennzeichnet**, dass die Isolierschichten (100, 102) zum Isolieren der Steuerbereiche (20, 22) vom Substratbereich (14) eine Isolierstärke von mindestens fünfzehn Nanometern oder mindestens zwanzig Nanometern haben.

4. Feldeffekttransistor (10) nach einem der vorhergehenden Ansprüche, **dadurch gekennzeichnet, dass** der Abstand zwischen den Anschlussbereichen (16, 18) mindestens 0,3 Mikrometer oder mindestens 0,4 Mikrometer beträgt.

5. Feldeffekttransistor (10) nach einem der vorhergehenden Ansprüche, **dadurch gekennzeichnet, dass** ein Anschlussbereich (16) oder beide Anschlussbereiche (16, 18) einen flachen Dotierprofilgradienten haben, welcher eine Schaltspannung mit einem Betrag größer als fünf Volt oder größer als neun Volt oder größer als fünfzehn Volt, jedoch vorzugsweise kleiner als dreißig Volt oder kleiner als zwanzig Volt zulässt.

6. Feldeffekttransistor (10) nach einem der vorhergehenden Ansprüche, **dadurch gekennzeichnet, dass** die dritte Isolierschicht Siliziumdioxid enthält oder aus Siliziumdioxid besteht.

7. Feldeffekttransistor (10) nach einem der vorhergehenden Ansprüche, **dadurch gekennzeichnet, dass** der andere Isolierbereich (110) Teil einer vierten Isolierschicht (110) ist, die eine Vielzahl von Substratbereichen (14) isoliert, vorzugsweise eine Silikatglasschicht.

8. Feldeffekttransistor (10) nach einem der vorhergehenden Ansprüche, **dadurch gekennzeichnet, dass** der Substratbereich (14) ein vorzugsweise einkristallines Halbleitermaterial enthält und/oder gemäß einem Leitungstyp dotiert ist und dass die Anschlussbereiche (16, 18) gemäß dem anderen Leitungstyp dotiert sind.

9. Feldeffekttransistor (10) nach einem der vorhergehenden Ansprüche, **dadurch gekennzeichnet, dass** die Steuerbereiche (20, 22) elektrisch leitfähig miteinander verbunden sind.

10. Feldeffekttransistor (10) nach einem der vorhergehenden Ansprüche, **dadurch gekennzeichnet, dass** der Substratbereich (14) sechs Seitenflächen enthält oder dass der Substratbereich (14) sechs Seitenflächen hat.

11. Feldeffekttransistor (10) nach einem der vorhergehenden Ansprüche, **dadurch gekennzeichnet, dass** die Steuerbereiche (20, 22) an einander gegenüberliegenden Seiten des Substratbereiches (14) angeordnet sind.

12. Verwendung eines Feldeffekttransistors (10) nach einem der vorhergehenden Ansprüche,
zum Schalten von Spannungen mit einem Betrag größer als größer als neun Volt oder größer als fünfzehn Volt, vorzugsweise jedoch kleiner als dreißig Volt.

13. Verwendung eines Feldeffekttransistors nach einem der vorhergehenden Ansprüche, als Ansteuertransistor an einer Wortleitung (372, 388) oder einer Bitleitung (396) eines Speicherzellenfeldes (330), eines Flash-Speichers oder eines EEPROM-Speichers,
wobei der Ansteuertransistor eine Steuerspannung an die Wortleitung (372, 388) oder an die Bitleitung (396) anlegt.

14. Verfahren zum Herstellen eines Feldeffekttransistors (10) nach einem der vorhergehenden Ansprüche,
mit den Verfahrensschritten:
Bildung eines Substratbereiches (14),
Bildung zweier Anschlussbereiche (16, 18) am Substratbereich (14), wobei der eine Anschlussbereich (16, 18) ein Sourcebereich (16) und der andere Anschlussbereich (16, 18) ein Drainbereich (18) ist,
Bildung zweier an einander gegenüberliegenden Seiten des Substratbereiches (14) angeordneter elektrisch isolierender Isolierschichten (100, 102), an denen Steuerbereiche (20, 22) angrenzen,
Bildung eines elektrisch leitfähigen Verbindungsbereiches (28; 28a, 230), der den einen Anschlussbereich (16) und den Substratbereich (14) elektrisch leitfähig verbindet,
wobei der leitfähige Verbindungsbereich (28) eine Metall-Halbleiter-Verbindung enthält oder aus einer Metall-Halbleiter-Verbindung besteht,
Einebnen der Oberfläche durch chemisch-mechanisches Polieren nach der Bildung der Steuerbereiche (20, 22),
Rückätzen der Steuerbereiche (20, 22) nach dem Polieren,
und Ausführen eines selbstjustierenden Verfahrens zur Bildung der Metall-Halbleiter-Verbindung, wobei in den rückgeätzten Bereichen und auf dem Substratbereich (14) und auf einem Anschlussbereich (16) eine Metall-Halbleiter-Verbindung erzeugt wird.

15. Verfahren nach Anspruch 14, **dadurch gekennzeichnet, dass** die Anschlussbereiche (16, 18) und/oder der Substratbereich (14) auf Siliziumbasis aufgebaut ist.

16. Verfahren nach Anspruch 14 oder 15, **dadurch gekennzeichnet, dass** der Verbindungsbereich (28) ein Silizid enthält oder aus Silizid besteht.

17. Verfahren nach einem der Ansprüche 14 bis 16, **dadurch gekennzeichnet, dass** der Verbindungsbereich mit einem selbstjustierenden Verfahren erzeugt wird, bei dem ein Metall abgeschieden wird, das an Halbleiterbereichen eine Metall-Halbleiter-Verbindung bildet.

18. Verfahren nach einem der Ansprüche 14 bis 17, **dadurch gekennzeichnet, dass** das Metall in Bereichen entfernt wird, in denen keine Metall-Halbleiter-Verbindungen gebildet worden sind, insbesondere kein Silizid.

19. Verfahren nach einem der Ansprüche 14 bis 18, **gekennzeichnet durch** die Schritte:
Bereitstellen eines SOI-Substrats (12),
Strukturieren des Siliziums des SOI-Substrats, wobei Bereiche stehen bleiben, in denen der Substratbereich (14) und die Anschlussbereiche (16, 18) angeordnet werden sollen,
Bildung der Steuerbereiche (20, 22) nach dem Strukturieren,
und/oder Auffüllen von freien Bereichen zwischen den stehen gebliebenen Bereichen mit einem elektrisch isolierenden Material (30).

20. Verfahren nach Anspruch 19, **gekennzeichnet durch** den Schritt:
Einebnen der Oberfläche nach dem Auffüllen.

21. Verfahren nach Anspruch 20, **gekennzeichnet durch** die Schritte:
Ausführen eines selbstjustierenden Salicid-Verfahrens zur Bildung der Metall-Halbleiter-Verbindung.

## Claims

1. Integrated field-effect transistor (10),
having a substrate region (14) surrounded:
by two terminal regions (16, 18) arranged at mutually opposite sides of the substrate region (14), one terminal region (16, 18) being a source region (16) and the other terminal region (16, 18) being a drain region (18),
by two electrically insulating insulating layers (100, 102), which are arranged at mutually opposite sides of the substrate region (14) and are adjoined by control regions (20, 22),
by two electrically insulating insulating regions (12, 110), the insulating regions (12, 110) being arranged at mutually opposite sides of the substrate region (14),
and one insulating region (12) at the bottom of the substrate region (14) being part of a third insulating layer which carries a multiplicity of field-effect transistors (10),
and by an electrically conductive connecting region (28) or a part (230) of an electrically conductive connecting region, which produces an electrically conductive connection between one terminal region (16) and the substrate region (14),
the conductive connecting region (28) containing a metal-semiconductor compound or comprising a metal-semiconductor compound,
a part of a covering area of the substrate region (14) being covered by the connecting region (28), the connecting region (28) extending further over a covering area of the source region (16),
and the part of the covering area of the substrate region (14) covering the substrate region (14) between the two insulating layers (100, 102) and between the two control regions (20, 22).

2. Field-effect transistor (10) according to Claim 1, **characterized in that** the conductive connecting region (28) comprises a silicide of a metal having a melting point of greater than 1400 degrees Celsius and/or a refractory metal silicide or a rare earth metal silicide.

3. Field-effect transistor (10) according to Claim 1 or 2, **characterized in that** the insulating layers (100, 102) for insulating the control regions (20, 22) from the substrate region (14) have an insulation strength of at least fifteen nanometers or at least twenty nanometers.

4. Field-effect transistor (10) according to one of the preceding claims, **characterized in that** the distance between the terminal regions (16, 18) is at least 0.3 micrometer or at least 0.4 micrometer.

5. Field-effect transistor (10) according to one of the preceding claims, **characterized in that** one terminal region (16) or both terminal regions (16, 18) have a shallow doping profile gradient which permits a switching voltage having a magnitude of greater than five volts or greater than nine volts or greater than 15 volts, but preferably less than thirty volts or less than 20 volts.

6. Field-effect transistor (10) according to one of the preceding claims, **characterized in that** the third insulating layer contains silicon dioxide or comprises silicon dioxide.

7. Field-effect transistor (10) according to one of the preceding claims, **characterized in that** the other insulating region (110) is part of a fourth insulating layer (110), which insulates a multiplicity of substrate regions (14), preferably a silicate glass layer.

8. Field-effect transistor (10) according to one of the preceding claims, **characterized in that** the substrate region (14) contains a preferably monocrystalline semiconductor material and/or is doped in accordance with one conduction type, and **in that** the terminal regions (16, 18) are doped in accordance with the other conduction type.

9. Field-effect transistor (10) according to one of the preceding claims, **characterized in that** the control regions (20, 22) are electrically conductively connected to one another.

10. Field-effect transistor (10) according to one of the preceding claims, **characterized in that** the substrate region (14) contains six side areas, or **in that** the substrate region (14) has six side areas.

11. Field-effect transistor (10) according to one of the preceding claims, **characterized in that** the control regions (20, 22) are arranged at mutually opposite sides of the substrate region (14).

12. Use of a field-effect transistor (10) according to one of the preceding claims,
for switching voltages having a magnitude of greater than nine volts or greater than fifteen volts, but preferably less than thirty volts.

13. Use of a field-effect transistor according to one of the preceding claims, as a driving transistor on a word line (372, 388) or a bit line (396) of a memory cell array (330), of a flash memory or of an EEPROM memory,
the driving transistor applying a control voltage to the word line (372, 388) or to the bit line (396).

14. Method for fabricating a field-effect transistor (10) according to one of the preceding claims,
having the method steps:
formation of a substrate region (14),
formation of two terminal regions (16, 18) at the substrate region (14), one terminal region (16, 18) being a source region (16) and the other terminal region (16, 18) being a drain region (18),
formation of two electrically insulating insulating layers (100, 102), which are arranged at mutually opposite sides of the substrate region (14) and are adjoined by control regions (20, 22),
formation of an electrically conductive connecting region (28; 28a, 230), which electrically conductively connects one terminal region (16) and the substrate region (14)
the conductive connecting region (28) containing a metal-semiconductor compound or comprising a metal-semiconductor compound,
levelling of the surface by chemical mechanical polishing after the formation of the control regions (20, 22),
etching-back of the control regions (20, 22) after polishing,
and performance of a self-aligning method for forming the metal-semiconductor compound, a metal-semiconductor compound being produced in the etched-back regions and
on the substrate region (14) and on a terminal region (16).

15. Method according to Claim 14, **characterized in that** the terminal regions (16, 18) and/or the substrate region (14) are/is constructed on the basis of silicon.

16. Method according to Claim 14 or 15, **characterized in that** the connecting region (28) contains a silicide, or comprises a silicide.

17. Method according to one of Claims 14 to 16, **characterized in that** the connecting region is produced by means of a self-aligning method in which a metal is deposited, which forms a metal-semiconductor compound at semiconductor regions.

18. Method according to one of Claims 14 to 17, **characterized in that** the metal is removed in regions in which no metal-semiconductor compounds were formed, in particular no silicide.

19. Method according to one of Claims 14 to 18, **characterized by** the following steps:
provision of an SOI substrate (12),
patterning of the silicon of the SOI substrate, regions remaining in which the substrate region (14) and the terminal regions (16, 18) are intended to be arranged,
formation of the control regions (20, 22) after the patterning,
and/or filling of free regions between the regions that remain with an electrically insulating material (30).

20. Method according to Claim 19, **characterized by** the following step:
leveling of the surface after the filling.

21. Method according to Claim 20, **characterized by** the following step:
performance of a self-aligning salicide method for forming the metal-semiconductor compound.

## Revendications

1. Transistor (10) à effet de champ intégré,
comprenant une zone (14) de substrat, qui est entourée :
de deux zones (16, 18) de borne, disposées sur des faces opposées l'une à l'autre de la zone (14) de substrat, l'une des zones (16, 18) de borne étant une zone (16) de source et l'autre zone (16, 18) de borne une zone (18) de drain,
de deux couches (100, 102) isolantes, isolantes électriquement, disposées sur deux faces opposées l'une à l'autre de la zone (14) de substrat, couches dont des zones (20, 22) de commande sont voisines,
de deux zones (12, 110) isolantes électriquement, les zones (12, 110) isolantes étant disposées sur des faces opposées l'une à l'autre de la zone (14) de substrat et une zone (12) isolante au fond de la zone (14) de substrat faisant partie d'une troisième couche isolante, qui porte une pluralité de transistors (10) à effet de champ,
et d'une zone (28) de connexion conductrice de l'électricité ou d'une partie (230) d'une zone de connexion conductrice de l'électricité, qui procure une connexion conductrice de l'électricité entre la une zone (16) de borne et la zone (14) de substrat,
dans lequel la zone (28) conductrice de connexion contient un composé métal-semiconducteur ou est constituée d'un composé métal-semiconducteur,
une partie d'une surface de recouvrement de la zone (14) de substrat étant recouverte par la zone (28) de connexion, la zone (28) de connexion s'étendant, en outre, sur une surface de recouvrement de la zone (16) de source,
et dans lequel la partie de la surface de recouvrement de la zone (14) de substrat recouvre la zone (14) de substrat entre les deux couches (100, 102) isolantes et entre les deux zones (20, 22) de commande.

2. Transistor (10) à effet de champ suivant la revendication 1, **caractérisé en ce que** la zone (28) conductrice de connexion est en un siliciure d'un métal ayant un point de fusion supérieur à 1 400 degrés Celsius et/ou un siliciure de métal réfractaire ou en un siliciure de métal des terres rares.

3. Transistor (10) à effet de champ suivant la revendication 1 ou 2, **caractérisé en ce que** les couches (100, 102) isolantes ont, pour isoler les zones (20, 22) de commande de la zone (14) de substrat, une épaisseur isolante d'au moins quinze nanomètres ou d'au moins vingt nanomètres.

4. Transistor (10) à effet de champ suivant l'une des revendications précédentes, **caractérisé en ce que** la distance entre les zones (16, 18) de borne est d'au moins 0,3 microns ou d'au moins 0,4 microns.

5. Transistor (10) à effet de champ suivant l'une des revendications précédentes, **caractérisé en ce qu'**une zone (16) de borne ou les deux zones (16, 18) de borne ont un gradient plat de profil de dopage, qui autorise une tension de commutation d'une valeur supérieure à cinq volts ou supérieure à neuf volts ou supérieure à quinze volts, mais, de préférence, inférieure à trente volts ou inférieure à vingt volts.

6. Transistor (10) à effet de champ suivant l'une des revendications précédentes, **caractérisé en ce que** la troisième couche isolante contient du dioxyde de silicium ou est constituée de dioxyde de silicium.

7. Transistor (10) à effet de champ suivant l'une des revendications précédentes, **caractérisé en ce que** l'autre zone (110) isolante fait partie d'une quatrième couche (110) isolante, qui isole une pluralité de zones (14) de substrat en étant, de préférence, une zone en verre au silicate.

8. Transistor (10) à effet de champ suivant l'une des revendications précédentes, **caractérisé en ce que** la zone (14) de substrat contient un matériau semiconducteur, de préférence monocristallin, et/ou est dopée suivant un type de conductivité et **en ce que** les zones (16, 18) de borne sont dopées suivant l'autre type de conductivité.

9. Transistor (10) à effet de champ suivant l'une des revendications précédentes, **caractérisé en ce que** les zones (20, 22) de commande sont reliées entre elles d'une manière conductrice de l'électricité.

10. Transistor (10) à effet de champ suivant l'une des revendications précédentes, **caractérisé en ce que** la zone (14) de substrat contient six surfaces latérales ou **en ce que** la zone (14) de substrat a six surfaces latérales.

11. Transistor (10) à effet de champ suivant l'une des revendications précédentes, **caractérisé en ce que** les zones (20, 22) de commande sont disposées sur des faces opposées l'une à l'autre de la zone (14) de substrat.

12. Utilisation d'un transistor (10) à effet de champ suivant l'une des revendications précédentes,
pour commuter des tensions d'une valeur supérieure à neuf volts ou supérieure à quinze volts, de préférence, toutefois, inférieure à trente volts.

13. Utilisation d'un transistor (10) à effet de champ suivant l'une des revendications précédentes, comme transistor de commande sur une ligne (372, 388) de mots ou sur une ligne (396) de bits d'un champ (330) de cellules de mémoire d'une mémoire flash ou d'une mémoire EEPROM,
dans laquelle le transistor de commande applique une tension de commande à la ligne (372, 388) de mots ou à la ligne (396) de bits.

14. Procédé de fabrication d'un transistor (10) à effet de champ suivant l'une des revendications précédentes,
comprenant les stades de procédé dans lesquels :
on forme une zone (14) de substrat,
on forme deux zones (16, 18) de borne sur la zone (14) de substrat, l'une des zones (16, 18) de borne étant une zone (16) de source et l'autre zone (16, 18) de borne étant une zone (18) de drain,
on forme deux couches (100, 102) isolantes, isolant du point de vue électrique, disposées sur des faces opposées de la zone (14) de substrat et dont des zones (20, 22) de commande sont voisines,
on forme une zone (28; 28a, 230) de connexion conductrice de l'électricité, qui relie d'une manière conductrice de l'électricité une zone (16) de borne et la zone (14) de substrat, la zone (28) de connexion conductrice contenant un composé métal-semiconducteur ou étant constituée d'un composé métal-semiconducteur,
on aplanit la surface par polissage chémiomécanique après la formation des zones (20, 22) de commande,
on attaque en retrait les zones (20, 22) de commande après le polissage et on effectue un procédé d'auto-alignement pour la formation du composé métal-semiconducteur en produisant un composé métal-semiconducteur dans les zones attaquées en retrait et sur la zone (14) de substrat et sur une zone (16) de borne.

15. Procédé suivant la revendication 14, **caractérisé en ce que** l'on forme les zones (16, 18) de borne et/ou la zone (14) de substrat à base de silicium.

16. Procédé suivant la revendication 14 ou 15, **caractérisé en ce que** la zone (28) de connexion contient un siliciure ou est constituée d'un siliciure.

17. Procédé suivant l'une des revendications 14 à 16, **caractérisé en ce que** l'on produit la zone de connexion par un procédé d'auto-alignement, dans lequel on dépose un métal qui forme un composé métal-semiconducteur sur les zones de semiconducteur.

18. Procédé suivant l'une des revendications 14 à 17, **caractérisé en ce que** l'on élimine le métal dans les zones dans lesquelles il n'a pas été formé de composé métal-semiconducteur, notamment pas de siliciure.

19. Procédé suivant l'une des revendications 14 à 18, **caractérisé par** les stades dans lesquels :
on se procure un substrat SOI 12,
on structure le silicium du substrat SOI en laissant des zones dans lesquelles la zone (14) de substrat et les zones (16, 18) de borne doivent être disposées,
on forme les zones (20, 22) de commande après la structuration et/ou on remplit d'un matériau (30) isolant du point de vue électrique des zones libres entre les zones délaissées.

20. Procédé suivant la revendication 19, **caractérisé par** le stade dans lequel :
on aplanit la surface après le remplissage.

21. Procédé suivant la revendication 20, **caractérisé par** le stade dans lequel :
on effectue un procédé au siliciure à auto-alignement pour la formation du composé métal-semiconducteur.
